# EUROPÄISCHE PATENTSCHRIFT

(11) **EP 2 099 567 B1**
(45) Veröffentlichungstag und Bekanntmachung des Hinweises auf die Patenterteilung: **21.08.2019**
(21) Anmeldenummer: 07866231.9
(22) Anmeldetag: 07.12.2007
(51) Int. Cl.: B01L 3/00, B29C 51/00, B81C 1/00

(54) **VORRICHTUNG ZUR AUFNAHME ODER MANIPULATION EINER FLÜSSIGKEIT**
DEVICE FOR THE INTAKE OR MANIPULATION OF A LIQUID
DISPOSITIF DE RÉCEPTION OU DE MANIPULATION D'UN LIQUIDE

(30) Priorität: 14.12.2006 DE 102006059459; 30.08.2007 DE 102007041352
(43) Veröffentlichungstag der Anmeldung: 16.09.2009
(73) Patentinhaber: Boehringer Ingelheim Microparts Gmbh, 44227 Dortmund (DE)
(72) Erfinder: BLANKENSTEIN, Gert, 44141 Dortmund (DE); RODENFELS, Tobias, 44265 Dortmund (DE); KUROWSKI, Dirk, 58285 Gevelsberg (DE); HEMPEL, Mario, 44267 Dortmund (DE)
(74) Vertreter: Von Rohr Patentanwälte Partnerschaft mbB
(86) Internationale Anmeldenummer: PCT/EP2007/010656
(87) Internationale Veröffentlichungsnummer: WO 2008/071351

(56) Entgegenhaltungen:
- US-A- 5 811 296
- US-A1- 2005 037 471
- US-A1- 2006 057 030
- US-A1- 2006 076 068
- US-B1- 6 902 706

## Beschreibung

Die vorliegende Erfindung betrifft ein Verfahren zur Herstellung einer Vorrichtung zur Aufnahme oder Manipulation eines Fluids, wie einer Flüssigkeit, gemäß dem Oberbegriff des Anspruchs 1.

Die vorliegende Erfindung befasst sich mit vorzugsweise mikrofluidischen Systemen bzw. Vorrichtungen. Die nachfolgenden Ausführungen beziehen sich insbesondere auf Vorrichtungen, bei denen Kapillarkräfte wirken und insbesondere für die Funktion entscheidend sind.

Es sind mikrofluidische Vorrichtungen mit Kammern insbesondere in Form von Kanälen bekannt, die durch eine dreidimensional geformte Folie zumindest partiell begrenzt und insbesondere elastisch deformierbar oder zusammendrückbar sind. Derartige Kammern bzw. Kanäle gestatten die Aufnahme und das Manipulieren, insbesondere Leiten, Mischen oder Fördern, von Flüssigkeiten.

Die US 6,902,706 B1 offenbart ein Ventil zur Steuerung einer Flüssigkeit in einem Analyse-Chip. Das Ventil weist einen ersten und einen zweiten Kanal auf, die aus der Oberseite eines plattenförmigen Trägers beabstandet voneinander austreten. Die austrittsseitigen Öffnungen sind durch eine Folie abgedeckt. Zum Öffnen des Ventils wird die Flüssigkeit unter Druck gesetzt, um die Folie dreidimensional zu verformen und so eine Verbindung zwischen den Öffnungen herzustellen. Es gibt keinen Hinweis, dass die Folie dreidimensional vorgeformt ist. Daher gibt es auch keinen Hinweis, dass die Folie allein durch das Auflaminieren dreidimensional vorgeformt wird.

Die US 2006/0076068 A1 offenbart mikrofluidische Strukturen aus im Wesentlichen steifen Membranen. In einem plattenförmigen Substrat sind auf einer Flachseite offene Kanäle angeordnet. Ein erstes Kanalende und ein zweites Kanalende sind voneinander beabstandet angeordnet und nicht miteinander verbunden. Das Substrat ist mit einer Folie laminiert, die eine nicht mit dem Substrat verbundene Region aufweist, die das erste und zweite Kanalende umfaßt. Bei Beaufschlagung der Folie mit Kräften verformt sich diese dreidimensional und es strömt Flüssigkeit vom ersten in den zweiten Kanal. Eine Folie, die durch das Auflaminieren dreidimensional vorgeformt ist, wird nicht offenbart.

Die US 2006/00570303 A1 offenbart eine Einrichtung zum Transport von Flüssigkeiten in Bio-Chips mit einer dreidimensional geformten Struktur aus Folie. Es gibt keinen Hinweis, die dreidimensionale Formung durch Auflaminieren der Folie zu bewirken.

Die WO 02/068823 A1 offenbart mikrofluidische Steuereinrichtungen, die als in eine Richtung wirkende Ventile verwendet werden können. Die Ventile werden durch ein Laminat aus fünf Schichten gebildet. Die Laminatschichten bilden einen Einlasskanal mit einem Ventilsitz, sowie einen Auslasskanal, der vom Einlasskanal durch eine flexible Membran getrennt ist. Die flexible Membran weist eine Öffnung auf, die gegen den Ventilsitz angeordnet ist. Bei Strömung im Einlasskanal wird die Membran gegen den Ventilsitz in Richtung Auslasskanal gedrückt und die Öffnung geschlossen. Bei umgekehrter Strömungsrichtung wird die Membrane vom Ventilsitz in Richtung Einlasskanal ausgelenkt und das Ventil geöffnet. Es gibt keine Hinweise auf Membranen, die allein durch das Laminieren dreidimensional vorgeformt werden.

Die WO 2005/060432 A2 offenbart eine Kassette für Analysezwecke. Ein Ventil weist ein flexibles Material auf, das bei einem bestimmten Druck von einer Barriere abgehoben, so dass ein Durchgang entsteht. Es wird kein flexibles Material, das allein durch das Laminieren dreidimensional vorgeformt wird, offenbart.

Die US 4,950,354 betrifft ein Verfahren zur Herstellung einer Luftpolsterfolie. Eine erwärmte thermoplastische Folie wird durch die Löcher eines perforierten Substrates gezogen, das vorher auf die Folie laminiert wurde. Die entstandenen blasenartigen Gebilde werden dann durch Lamination einer weiteren thermoplastischen Folie auf das vorhandene Laminat geschlossen.

Die US 2006/0076068 A1 offenbart eine mikrofluidische Vorrichtung mit einem starren Kunststoffträger aus Polymethyl oder Polycarbonat, wobei eine Kunststoffmembran unter Hitzeeinwirkung mit dem Kunststoffträger verbunden wird. Die auflaminierte Kunststoffmembran wird anschließend mit Flüssigkeit beaufschlagt, so dass sie sich gegenüber dem Kunststoffträger aufwölbt.

Die US 2006/0057030 A1 offenbart eine mikrofluidische Vorrichtung zum Transport eines Fluids. Auf ein Substrat wird unter Druck- und Hitzeeinwirkung eine elastische Deckschicht geklebt. Eine Aufwölbung bzw. Strukturierung der Deckschicht erfolgt durch ein Einleiten von Druckgas zwischen dem Substrat und der darauf bereits befestigten Deckschicht.

Die US 5,811,296 beschreibt ein Verfahren, bei dem zwei Folien "geblockt", das heißt temporär bzw. wieder lösbar durch aufeinanderpressen unterhalb einer Heißsiegeltemperatur miteinander verbunden werden.

Der vorliegenden Erfindung liegt die Aufgabe zugrunde, ein Verfahren zur Herstellung einer Vorrichtung zur Aufnahme oder Manipulation eines Fluids, insbesondere einer Flüssigkeit, anzugeben, wobei auf besonders einfache Weise eine zumindest partiell deformierbare, insbesondere elastisch verformbare Kammer oder sonstige dreidimensionale von einer Folie begrenzte Struktur bereitgestellt werden kann.

Die obige Aufgabe wird durch ein Verfahren gemäß Anspruch 1 gelöst. Vorteilhafte Weiterbildungen sind Gegenstand der Unteransprüche.

Ein Aspekt der vorliegenden Erfindung liegt darin, eine flache und/oder nicht vorgeformte Deckfolie auf einen Träger zu laminieren (also durch Hitze- und Druckeinwirkung) und aus der Deckfolie eine allein durch das Auflaminieren dreidimensional geformte oder gewölbte Kammerwand zu bilden, die eine gewünschte Kammer zwischen Deckfolie und Träger partiell begrenzt. Dies gestattet eine besonders einfache Herstellung.

Insbesondere wird zum Laminieren eine Maske bzw. sogenannte Termode (beheizter Stempel) mit mindestens einer Ausnehmung oder Durchbrechung auf die Deckfolie unter Hitzeeinwirkung gepresst, so dass vorzugsweise ausschließlich hierdurch die Deckfolie im Bereich der Ausnehmung bzw. Durchbrechung nicht mit dem Träger verbunden, sondern in diesem Bereich dreidimensional geformt bzw. strukturiert wird. In den anderen Bereichen wird die Deckfolie jedoch vorzugsweise in üblicher Weise durch das Auflaminieren fest mit dem Träger verbunden. So kann auf sehr einfache Weise eine Strukturierung bzw. Formung der Deckfolie erfolgen, um eine dreidimensionale Struktur, wie eine Kammer, für ein Fluid, wie einer Flüssigkeit, insbesondere zu deren Aufnahme und/oder Manipulation, zu bilden.

Vorzugsweise wird die Deckfolie von einer Zusatzfolie zumindest partiell und/oder im Bereich einer von der Deckfolie gebildeten Kammer überdeckt, wobei zwischen der Deckfolie und der Zusatzfolie eine Zusatzkammer gebildet wird. Besonders bevorzugt wird die Zusatzfolie ebenso wie die Deckfolie auflaminiert, wobei die Zusatzfolie insbesondere allein durch das Auflaminieren wiederum eine dreidimensional geformte oder gewölbte Zusatzwand bildet, die die Zusatzkammer bildet bzw. partiell begrenzt. So kann eine universell einsetzbare dreidimensionale Struktur auf besonders einfache Art und Weise bereitgestellt werden.

Jedoch ist es grundsätzlich auch möglich, die Deckfolie und/oder Zusatzfolie auf eine sonstige Art und Weise aufzubringen und/oder dreidimensional zu verformen.

Vorzugsweise überdeckt die Deckfolie bzw. davon gebildete Kammer eine Membran, so dass insbesondere durch die Membran hindurchtretendes Permeat in der Kammer aufgenommen und insbesondere über einen angeschlossenen Kanal oder dergleichen abgeführt werden kann. Besonders bevorzugt ist die Deckfolie mittig mit der Membran - insbesondere durch Laminieren - verbunden. So kann eine sehr hohe Kapillarkraft und damit eine sehr effiziente Abtrennung bzw. Filtration erreicht werden, besonders bevorzugt bei der Bluttrennung oder dergleichen.

Unter dem Begriff "Kammer" ist bei der vorliegenden Erfindung insbesondere jede beliebige dreidimensionale Struktur - beispielsweise ein länglicher Kanal - zu verstehen, die vorschlagsgemäß herstellbar ist bzw. durch die dreidimensional geformte oder strukturierte Deckfolie begrenzt wird und der Aufnahme von Flüssigkeit oder eines sonstigen Fluids, gegebenenfalls auch Gas, dient. Entsprechendes gilt auch für den Begriff "Zusatzkammer".

Die vorliegende Erfindung betrifft insbesondere nur mikrofluidische Vorrichtungen bzw. Strukturen. Unter "mikrofluidisch" sind hier insbesondere nur Volumina der gesamten Vorrichtung oder der Kammer von höchstens 100 µl, besonders bevorzugt 10 µl oder weniger, zu verstehen.

Weitere Vorteile, Merkmale, Eigenschaften und Aspekte der vorliegenden Erfindung ergeben sich aus den Ansprüchen und der folgenden Beschreibung bevorzugter Ausführungsformen anhand der Zeichnung. Es zeigt:
- Fig. 1: eine ausschnittsweise Draufsicht einer vorschlagsgemäßen Vorrichtung gemäß einer ersten Ausführungsform;
- Fig. 2: einen schematischen Schnitt entlang Linie II-II von Fig. 1;
- Fig. 3: einen schematischen Schnitt entlang Linie III-III von Fig. 1, wobei ein Auflaminieren noch nicht erfolgt ist;
- Fig. 4: einen zu Fig. 3 korrespondierenden, schematischen Schnitt nach dem Auflaminieren;
- Fig. 5: eine schematische Draufsicht einer in Fig. 3 angedeuteten Maske bzw. Termode;
- Fig. 6: eine schematische Draufsicht einer vorschlagsgemäßen Vorrichtung gemäß einer zweiten Ausführungsform;
- Fig. 7: ein schematischer Schnitt entlang Linie VII-VII von Fig. 6;
- Fig. 8: eine schematische Draufsicht einer vorschlagsgemäßen Vorrichtung gemäß einer dritten Ausführungsform;
- Fig. 9: einen schematischen Schnitt entlang Linie VIII-VIII von Fig. 8;
- Fig. 10: eine schematische Draufsicht einer vorschlagsgemäßen Vorrichtung gemäß einer vierten Ausführungsform;
- Fig. 11: einen schematischen Schnitt entlang Linie XI-XI von Fig. 10;
- Fig. 12: eine ausschnittsweise Draufsicht einer vorschlagsgemäßen Vorrichtung gemäß einer fünften Ausführungsform;
- Fig. 13: einen schematischen Schnitt einer vorschlagsgemäßen Vorrichtung gemäß einer sechsten Ausführungsform;
- Fig. 14: eine schematische Draufsicht einer vorschlagsgemäßen Vorrichtung gemäß einer siebten Ausführungsform;
- Fig. 15: einen schematischen Schnitt entlang Linie XV-XV von Fig. 14;
- Fig. 16: einen schematischen Schnitt einer vorschlagsgemäßen Vorrichtung gemäß einer achten Ausführungsform;
- Fig. 17: eine schematische Draufsicht der Vorrichtung gemäß Fig. 16;
- Fig. 18: eine schematische Draufsicht der Vorrichtung gemäß Fig. 16 beim Öffnen eines Kanals;
- Fig. 19: eine schematische Draufsicht einer vorschlagsgemäßen Vorrichtung gemäß einer neunten Ausführungsform;
- Fig. 20: eine Unteransicht einer Maske bzw. Termode für die Vorrichtung gemäß Fig. 19;
- Fig. 21: einen schematischen Schnitt einer vorschlagsgemäßen Vorrichtung gemäß einer zehnten Ausführungsform;
- Fig. 22: eine Draufsicht der Vorrichtung gemäß Fig. 21;
- Fig. 23: einen schematischen Schnitt einer vorschlagsgemäßen Vorrichtung gemäß einer elften Ausführungsform; und
- Fig. 24: einen schematischen Schnitt einer vorschlagsgemäßen Vorrichtung gemäß einer zwölften Ausführungsform.

In den Figuren werden für gleiche oder ähnliche Teile dieselben Bezugszeichen verwendet, wobei entsprechende oder vergleichbare Eigenschaften und Vorteile erreicht werden, auch wenn eine wiederholte Beschreibung weggelassen ist. Die Fig. sind zur Verdeutlichung verschiedener Aspekte und zur Erleichterung der Beschreibung nicht maßstabsgerecht.

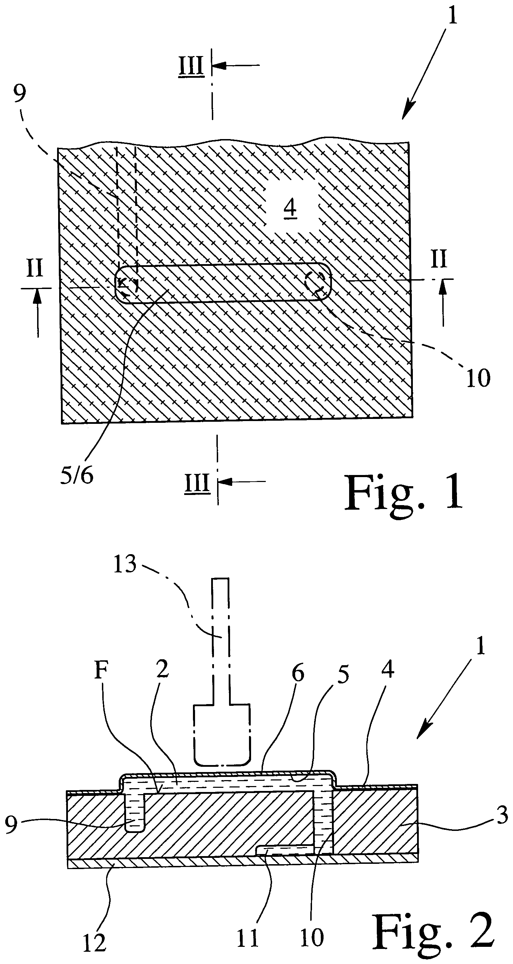

Fig. 1 zeigt in einer ausschnittsweisen, schematischen Draufsicht eine vorschlagsgemäß hergestellte Vorrichtung 1 zur Aufnahme und/oder Manipulation eines Fluids, insbesondere einer Flüssigkeit. Das Fluid bzw. die Flüssigkeit ist in Fig. 1 nicht dargestellt. Vielmehr zeigt der schematische Schnitt gemäß Fig. 2 entlang Linie II-II von Fig. 1 beispielhaft die Vorrichtung 1 mit der Flüssigkeit 2.

Die Vorrichtung 1 weist einen Träger 3 und eine Deckfolie 4 auf. Zwischen dem Träger 3 und der Deckfolie 4 ist eine dreidimensionale fluidische Struktur zur Aufnahme bzw. Manipulation des Fluids gebildet. Insbesondere handelt es sich bei der Struktur um eine vorzugsweise kanalförmige Kammer 5.

Die Struktur bzw. Kammer 5 ist zumindest teilweise durch eine Kammerwand 6 begrenzt, die in bzw. von der Deckfolie 4 gebildet ist. Insbesondere ist der Träger 3 zumindest in diesem Bereich flach bzw. eben - mit Ausnahme eventueller Zu- oder Ableitungen für das Fluid - ausgebildet, so dass die Struktur bzw. Kammer 5 im wesentlichen oder quasi ausschließlich in der Deckfolie 4 bzw. außerhalb des Trägers 3 oder oberhalb von dessen Flachseite F gebildet ist.

Die Deckfolie 4 wird auf den Träger 3, insbesondere die Flachseite F des Trägers 3, auflaminiert, also unter Druck- und Hitzeeinwirkung (bei etwa 80 - 100 °C) mit dem Träger 3 verbunden.

Vor dem Auflaminieren wird die flache Deckfolie 4 vorschlagsgemäß weder vorgeformt noch dreidimensional strukturiert oder dergleichen, um die dreidimensional geformte und/oder gewölbte Kammerwand 6 zu bilden. Vielmehr wird die Deckfolie 4 erst durch das Auflaminieren derart verformt, strukturiert und/oder vorgespannt, dass die dreidimensional geformte bzw. gewölbte Kammerwand 6 gebildet wird, insbesondere von dem Träger 3 weg gewölbt bzw. verformt wird und/oder insbesondere ohne Ausüben eines Drucks, beispielsweise Gasdrucks, auf die Kammerwand 6.

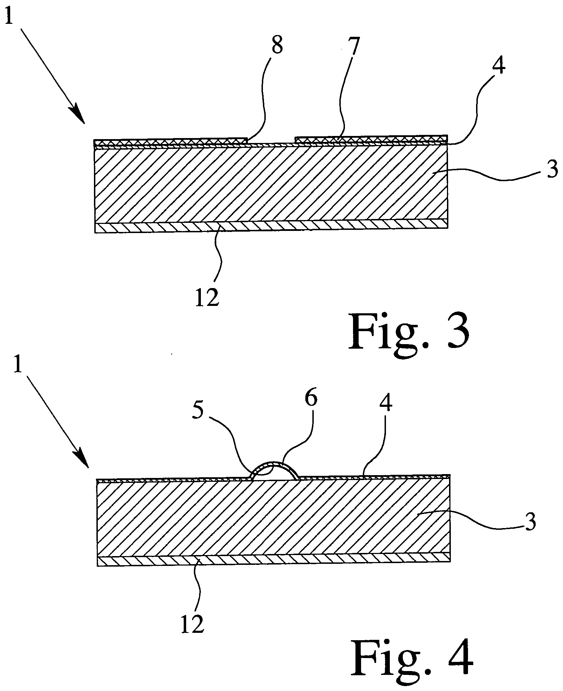

Der schematische Schnitt gemäß Fig. 3 entlang Linie III-III von Fig. 1 zeigt die zunächst glatte bzw. flache Deckfolie 4 auf dem Träger 3 noch vor dem Auflaminieren, also vor Bildung der Kammer 5.

Das Auflaminieren erfolgt vorschlagsgemäß insbesondere mit einer sogenannten Termode oder Maske 7, die beispielsweise von einem entsprechend ausgebildeten Stempel, einer Zwischenlage oder dergleichen gebildet ist. Bedarfsweise kann die Maske 7 auch von der Oberfläche einer Rolle oder Walze eines Rollenlaminators oder dergleichen gebildet sein.

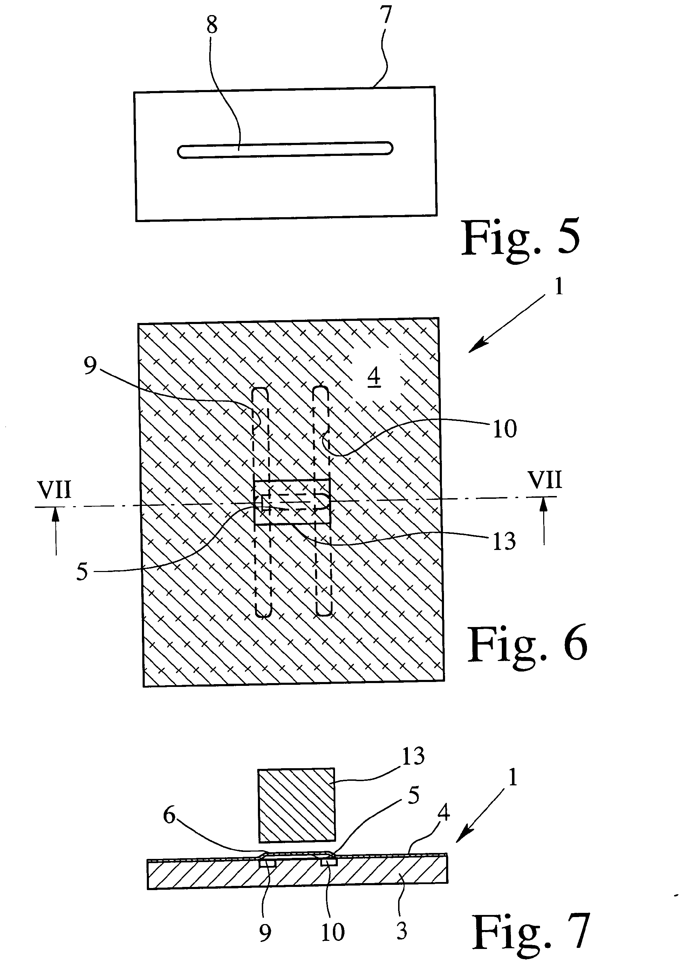

Die Maske 7 weist hier mindestens eine Ausnehmung oder Durchbrechung 8 auf, wie in Fig. 3 und in der Ansicht von unten gem. Fig. 5 angedeutet.

Zum Laminieren wird die Maske 7 unter Hitzeeinwirkung auf die auf dem Träger 3 insbesondere zunächst lose aufliegende Deckfolie 4 gepresst. Hierdurch wird die Deckfolie 4 vorzugsweise ausschließlich im Bereich der Ausnehmung bzw. Durchbrechung 8 nicht mit dem Träger 3 verbunden, sondern in diesem Bereich dreidimensional geformt bzw. strukturiert, wie in Fig. 4 angedeutet. Überraschenderweise hat sich nämlich gezeigt, dass ohne zusätzlichen Verformungsschritt und insbesondere ohne Einsatz eines Blähmittels, von Druckgas oder dergleichen im Bereich der Ausnehmung bzw. Durchbrechung 8 der Maske 7 die Deckfolie 4 aufgewölbt wird, wodurch die dreidimensional geformte bzw. gewölbte Kammerwand 6 gebildet wird, wie in Fig. 4 schematisch dargestellt.

Das vorschlagsgemäße dreidimensionale Verformen der Deckfolie 4 kann insbesondere wahlweise mit einem nicht dargestellten Stempellaminator oder Rollenlaminator durchgeführt werden.

Das vorschlagsgemäße Laminieren ist insbesondere sehr einfach durchführbar, da zusätzliche Verformungsschritte entfallen. Die Maske 7 ist sehr einfach herstellbar, da insbesondere keine dreidimensionale Strukturierung der Maske 7 erforderlich ist. Vielmehr genügt ist, eine Durchbrechung 8 oder mehrere Durchbrechungen 8 mit den gewünschten Konturen zu bilden.

Die Kammer 5 ist beim Darstellungsbeispiel im Wesentlichen kanalförmig bzw. länglich und/oder kanalartig oder wulstartig ausgebildet, wie in der Draufsicht gemäß Fig. 1 und im Schnitt gemäß Fig. 2 angedeutet. Quer dazu ist die Kammer 5 vorzugsweise relativ dünn und insbesondere im Querschnitt im wesentlichen halbkreisförmig ausgebildet, wie in dem quer zu Fig. 2 verlaufenden Schnitt gemäß Fig. 4 angedeutet. Insbesondere ist die von der Deckfolie 4 gebildete Kammerwandung 6 quer zur Längserstreckung der Kammer 5 gewölbt bzw. halbrund ausgebildet. Jedoch sind grundsätzlich auch sonstige Konfigurationen, Formen und Strukturierungen möglich.

Die vorschlagsgemäß in der Deckfolie 4 gebildete Struktur bzw. Kammer 5 ist beispielsweise mit einem ersten Kanal 9 und/oder einem zweiten Kanal 10 der Vorrichtung 1 bzw. des Trägers 3 oder einer sonstigen fluidischen Struktur, einem fluidischen Bauelement oder dergleichen fluidisch verbunden. Beim Darstellungsbeispiel verläuft der erste Kanal 9 beispielsweise entlang der Flachseite F. Er ist beispielsweise durch eine Nut im Träger 3 gebildet, die insbesondere von der Deckfolie 4 flach abgedeckt ist. Der erste Kanal 9 endet oder beginnt mit einem Ende beispielsweise an einem Endbereich der Kammer 5.

Beim Darstellungsbeispiel schließt sich der zweite Kanal 10 insbesondere an das andere Ende der Kammer 5 an. Beispielsweise ist der zweite Kanal 10 als Durchbrechung bzw. Bohrung durch den Träger 3 hindurch ausgebildet und verbindet die Kammer 5 fluidisch mit einer auf der anderen Flachseite des Trägers 3 angeordneten fluidischen Struktur 11, wie einem Kanal, einem Detektionsbereich, einem Mischbereich oder dergleichen.

Die Struktur 11 ist vorzugsweise ebenfalls im Träger 3 gebildet und beispielsweise durch eine Abdeckung 12 abgedeckt, bei der es sich wiederum um eine Deckfolie, insbesondere aus dem gleichen Material wie die obere Deckfolie 4, handeln kann.

Die vorschlagsgemäße Vorrichtung 1 bildet insbesondere eine mikrofluidische Plattform bzw. ein mikrofluidisches System zur Aufnahme oder Manipulation eines Fluids, wie der Flüssigkeit 2.

Insbesondere ist die Kammer 5 bzw. die Kammerwand 6 elastisch oder reversibel verformbar. Die Rückstellung kann insbesondere aufgrund entsprechender Rückstellkräfte der Deckfolie 4 bzw. Kammerwand 6 und/oder aufgrund des in der Kammer 5 herrschenden Fluiddrucks erfolgen.

Zur Verformung kann beispielsweise ein in Fig. 2 schematisch angedeutetes Teil oder Element 13, wie ein Stempel, eine Rolle, eine Walze, ein Schieber, ein sonstiger Aktuator oder dergleichen, auf die Kammerwand 6 einwirken.

Das Element 13 ist beispielsweise quer zur Längserstreckung der Kammer 5 bzw. zur Flachseite F bzw. Plattenebene des Trägers 3 bewegbar, so dass die Kammerwand 6 im Bereich des Elements 13 auf den Träger 3 drückbar und dadurch ein fluidischer Fluss durch die Kammer 5 in der Art eines Quetschventils unterbrechbar bzw. sperrbar oder drosselbar, insbesondere steuerbar bzw. regulierbar ist.

Das Element 13 kann beispielsweise insbesondere bei länglicher Ausbildung der Kammer 5 auch in Längsrichtung entlang der Kammer 5 unter lokalem Zusammendrücken der Kammer 5 bewegt werden, wodurch eine Förderung bzw. Verdrängung des Fluids 2 in der Kammer 5 in der Art einer Schlauchpumpe erreicht werden kann. In diesem Fall bildet die Kammer 5 also insbesondere einen deformierbaren Pumpraum.

In den beiden vorgenannten Anwendungsbeispielen ist die Quererstreckung der auf die Kammer 5 bzw. Kammerwand 6 einwirkenden Fläche des Elements 13 vorzugsweise zumindest im Wesentlichen mindestens ebenso groß wie die Breite der Kammer 5 quer zu ihrer Längserstreckung. Jedoch kann das Element 13 relativ zu dieser Breite auch relativ schmal bzw. klein ausgebildet sein. Insbesondere in diesem Fall eignet sich das Element 13 besonders, um das Fluid in der Kammer 5 beispielsweise hin und her oder bei entsprechender Ausbildung der Kammer 5 beispielsweise auch im Kreis bzw. Umlauf zu bewegen, beispielsweise um verschiedene Fluide oder eine Dispersion zu mischen. In diesem Fall bildet die Kammer 5 also insbesondere einen Mischraum.

Es ist anzumerken, dass die vorschlagsgemäß ausgebildete Vorrichtung 1 für verschiedenste Zwecke, beispielsweise zur insbesondere gesteuerten Be- oder Entlüftung, eingesetzt und insbesondere auch mit sonstigen insbesondere mikrofluidischen Systemen, Bauelementen, wie Ventilen, Pumpen, Kapillarstops, Filtern, Detektionseinrichtungen oder dergleichen, kombiniert werden kann.

Die vorschlagsgemäße Vorrichtung 1 ist beispielsweise auch zur Analyse oder sonstigen Behandlung oder Manipulation von Fluiden, wie der Flüssigkeit 2, einsetzbar.

Beim Darstellungsbeispiel ist der Träger 3 vorzugsweise aus Kunststoff, insbesondere Polystyrol oder Polycarbonat, hergestellt.

Der Träger 3 ist vorzugsweise zumindest im Wesentlichen plattenförmig, flach und/oder eben ausgebildet.

Vorzugsweise ist der Träger 3 zumindest im Wesentlichen starr ausgebildet.

Insbesondere ist der Träger 3 oder dessen Oberfläche aus einem Material gebildet, das temperaturbeständiger als die Deckfolie 4 oder eine Heißsiegelschicht der Deckfolie 4 ist.

Die Deckfolie 4 ist vorzugsweise aus Kunststoff, insbesondere Polyethylen oder Polypropylen, hergestellt.

Die Deckfolie 4 ist transparent oder undurchsichtig ausgebildet, ggf. auch nur bereichsweise.

Die Deckfolie 4 ist wahlweise einschichtig oder mehrschichtig aufgebaut. Dies hängt von den jeweiligen Anwendungszwecken und Anforderungen ab.

Es handelt sich bei der Deckfolie 4 um eine sogenannte Heißsiegelfolie, die üblicherweise eine Beschichtung aus Siegellack oder dergleichen aufweist.

Je nach Bedarf kann die Deckfolie 4 auch mehrere dreidimensional geformte oder gewölbte Kammerwände 6 verschiedener Kammern 5 bilden.

Wie bereits erwähnt, kann die Deckfolie 4 auch eine sonstige fluidische Struktur oder alle sonstigen fluidischen im oder am Träger 3 abdecken oder bilden, wie eine Ausnehmung, eine Vertiefung, eine Durchbrechung, eine Nut oder den ersten Kanal 9 und/oder mehrere Kammern 5 o. dgl.

Nachfolgend werden weitere Ausführungsformen und -varianten der vorschlagsgemäßen Vorrichtung 1 anhand der weiteren Figuren erläutert. Zur Vermeidung von Wiederholungen werden insbesondere nur wesentliche Unterschiede beschrieben, so dass die bisherigen Ausführungen und Erläuterungen insbesondere entsprechend bzw. ergänzend gelten.

Fig. 6 zeigt in einer Draufsicht eine zweite Ausführungsform der vorschlagsgemäß hergestellten Vorrichtung 1. Hier laufen der erste und zweite Kanal 9, 10 in einer Ebene und/oder zumindest im Wesentlichen parallel zueinander. Die beiden Kanäle 9, 10 sind durch die von der Deckfolie 4 gebildete Kammer 5 miteinander verbunden bzw. verbindbar.

Fig. 6 zeigt die Vorrichtung 1 mit dem über der Kammer 5 angeordneten Element 13. Fig. 7 zeigt einen schematischen Schnitt der Vorrichtung 1 gemäß Fig. 6 entlang Linie VII-VII. Hier ist das Element 13 noch abgehoben. In diesem Fall ist die fluidische Verbindung der beiden Kanäle 9, 10 über die Kammer 5 geöffnet, insbesondere die Kammerwandung 6 nach oben bzw. von der Flachseite F des Trägers 3 aufgewölbt bzw. erhaben.

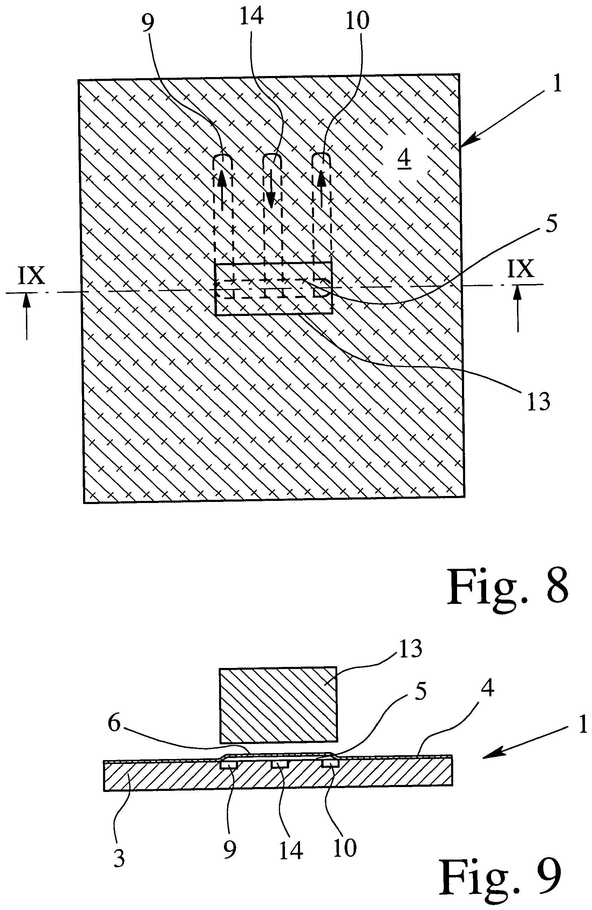

Fig. 8 zeigt in einer schematischen Draufsicht eine dritte Ausführungsform der vorschlagsgemäßen Vorrichtung 1, die der zweiten Ausführungsform sehr ähnlich ist. Hier ist zusätzlich ein dritter Kanal 14 vorgesehen. Der dritte Kanal 14 dient beispielsweise der Zuführung eines Fluids, wie einer Waschflüssigkeit oder dergleichen. Über die Kammer 5 ist der dritte Kanal 14 mit den beiden anderen Kanälen 9, 10 verbunden bzw. verbindbar. Fig. 8 veranschaulicht den Zustand bei hergestellter Verbindung. Die Pfeile geben mögliche Strömungsrichtungen an. Die über den Kanal 14 zugeführte Flüssigkeit wird beispielsweise über die beiden anderen Kanäle 9 und 10 wieder abgeführt.

Bei der gezeigten dritten Ausführungsform ist die fluidische Verbindung zu den beiden außen liegenden Kanälen 9, 10 vorzugsweise simultan sperrbar oder freigebbar oder drosselbar. Entsprechend breit oder lang ist hierzu das zugeordnete Element 13 zur Steuerung der fluidischen Verbindung ausgebildet. Je nach Verquetschen oder Verformen der im nicht unterbrochenen Zustand gewölbten Kammerwand 6 kann die fluidische Verbindung mehr oder weniger gedrosselt oder schließlich vollständig unterbrochen werden.

Der schematische Schnitt gemäß Fig. 9 entlang Linie VIII-VIII von Fig. 8 veranschaulicht eine mögliche, relativ breite Ausbildung des Elements 13. Hier erstreckt sich das Element 13 insbesondere bis zu den oder gar über die beiden randseitigen Kanäle 9, 10 - genauer gesagt deren Anschlüsse an die Kammer 5. Jedoch sind auch andere konstruktive Lösungen möglich.

Insbesondere ist es auch möglich, dass die fluidische Verbindung vom dritten Kanal 14 zu dem Kanal 9 einerseits und zu dem Kanal 10 andererseits unabhängig voneinander steuerbar ist. In diesem Fall sind insbesondere zwei separate bzw. unabhängig voneinander steuerbare oder betätigbare Elemente 13 der Kammer 5 zugeordnet. Jedoch kann dieser Effekt bei entsprechender Verschiebung, Kammerverdrehung oder dergleichen auch wahlweise nur mit einem einzigen, wie dem gezeigten Element 13 oder einem sonstigen Element 13 erreicht werden.

Es ist anzumerken, dass je nach Zusammendrücken der Kammer 5 auch eine Drosselung der fluidischen Verbindung erreichbar ist. Die vorschlagsgemäße Vorrichtung 1 ist insbesondere also nicht nur als Ventil sondern auch als Drossel oder sonstiges Element zur fluidischen Manipulation einsetzbar.

Beispielsweise kann die Vorrichtung 1 auch zur gesteuerten Be- und/oder Entlüftung eingesetzt werden. In diesem Fall kann insbesondere eine quasi indirekte Steuerung einer zugeordneten Flüssigkeit oder dergleichen erfolgen. Wie bei der ersten Ausführungsform sind bei der zweiten und dritten Ausführungsform die Kanäle 8, 9, 14 jeweils vorzugsweise durch Ausnehmungen, Nuten oder dergleichen im Träger 3 und vorzugsweise Abdeckung durch die Deckfolie 4 gebildet. Jedoch sind auch andere konstruktive Lösungen möglich. Insbesondere können die Kanäle 9, 10 und/oder 14 auch durch Bohrungen, Schläuche, sonstige Abdeckelemente oder Träger oder dergleichen, gebildet, begrenzt, geführt oder verbunden sein.

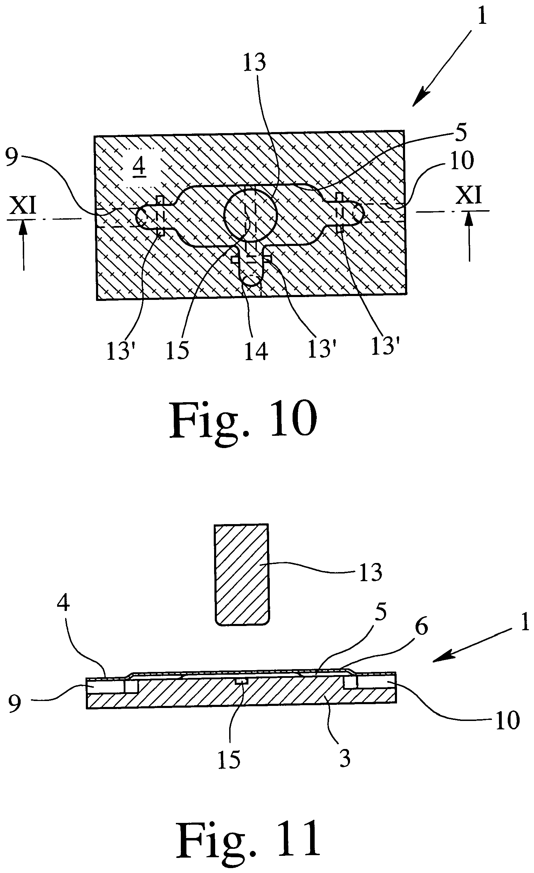

Fig. 10 zeigt in einer schematischen Draufsicht eine vierte Ausführungsform der vorschlagsgemäßen Vorrichtung 1. Hier bildet die Kammer 5 insbesondere eine Mischkammer. Über die beiden beispielsweise entgegengesetzten Kanäle 9 und 10 sind insbesondere unterschiedliche Flüssigkeiten oder sonstige Fluide zuführbar. In der Kammer 5 ist vorzugsweise eine Stoppstruktur, insbesondere eine kapillare Stoppstruktur 15, beispielsweise durch eine quer verlaufende Nut, eine Erhebung, einen hydrophoben Bereich, einen hydrophilen Bereich oder dergleichen gebildet. Der an die Mischkammer vorzugsweise über einen Kapillarstop angeschlossene dritte Kanal 14 dient hier insbesondere einer Entlüftung der Kammer 5.

Nach dem Füllen der Kammer 5 sind die Kanäle 9, 10 und gegebenenfalls auch 14 insbesondere durch Ventile oder sonstige Einrichtungen vorzugsweise fluidisch schließbar, besonders bevorzugt durch Verquetschen mittels zusätzlicher Elemente 13', wie gestrichelt nur in Fig. 10 angedeutet. Anschließend wird das Element 13 auf die gewölbte Kammerwandung 6 gedrückt und insbesondere kreisförmig und/oder linear hin und her bewegt. So kann ein Mischen der in der Kammer 5 befindlichen Flüssigkeiten durch insbesondere nur bereichsweises Eindrücken oder Verformen der Kammerwand 5 erreicht werden.

Nach dem definierten Mischen und Öffnen mindestens einer fluidischen Verbindung können die Flüssigkeiten bspw. durch Verquetschen der Kammer 5 weitertransportiert bzw. wieder ausgegeben werden.

Fig. 11 zeigt in einem schematischen Schnitt entlang Linie XI-XI von Fig. 10 die Vorrichtung 1 mit abgehobenem Element 13.

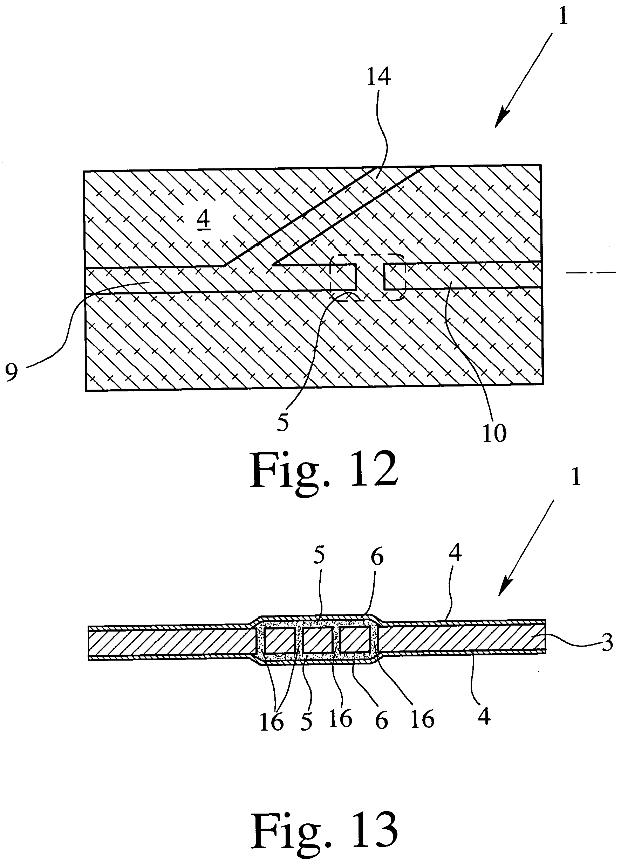

Fig. 12 zeigt in einer schematischen Draufsicht eine fünfte Ausführungsform der vorschlagsgemäßen Vorrichtung 1. Hier ist die von der Deckfolie 4 gebildete Kammer 5 vorzugsweise zwischen dem ersten Kanal 9 und dem zweiten Kanal 10 angeordnet bzw. verbindet diese beiden Kanäle. Der erste Kanal 9 weist stromauf der Kammer 5 eine Abzweigung zum sich anschließenden dritten Kanal 14 auf.

Wenn dem ersten Kanal 9 ein Fluid, beispielsweise eine Flüssigkeit mit Zellen oder dergleichen, zugeführt wird, kann mittels der verformbaren bzw. absperrbaren Kammer 5 selektiv bzw. gezielt gesteuert werden, ob das Fluid und die Zellen o. dgl. über die Kammer 5 in den zweiten Kanal 10 weiterströmen oder bei entsprechendem Absperren oder Drosseln (Verquetschen der Kammer 5) über die Abzweigung in den dritten Kanal 14 weitergeleitet werden. So ist beispielsweise ein Zellsortierer realisierbar. Jedoch ist diese Anordnung auch für sonstige Zwecke in der Fluidik, insbesondere in der Mikrofluidik, einsetzbar.

Fig. 13 zeigt in einem schematischen Schnitt eine sechste Ausführungsform der vorschlagsgemäßen Vorrichtung 1. Hier ist auf zwei gegenüberliegenden Seiten, insbesondere Flachseiten, des Trägers 3 jeweils eine Kammer 5 durch jeweils eine - vorzugsweise wie bereits beschrieben auflaminierte - Deckfolie 4 gebildet. Die beiden auf voneinander abgewandten Seiten des Trägers 3 und/oder gegenüberliegenden Kammern 5 sind vorzugsweise durch Durchbrechungen, Poren, Bohrungen, Kanäle 16 oder dergleichen im Träger 3 vorzugsweise unmittelbar miteinander verbunden. Durch entsprechendes, insbesondere abwechselndes Verformen oder Verquetschen der Kammern 5 bzw. deren Kammerwandungen 6 ist es möglich, in den Kammern 5 befindliche Flüssigkeit von einer Kammer 5 in die andere Kammer 5 und umgekehrt abwechselnd strömen zu lassen. Dies ist insbesondere einem guten Durchmischen von Flüssigkeiten, einer Reaktion mit einem Reagenz, das beispielsweise am oder im Träger 3 vorliegt, oder dergleichen zuträglich.

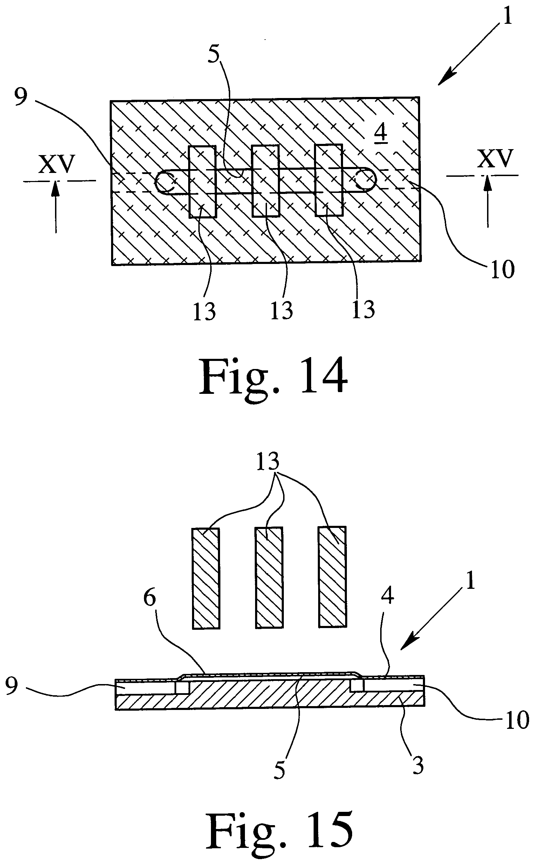

Fig. 14 zeigt in einer schematischen Draufsicht eine siebte Ausführungsform der vorschlagsgemäßen Vorrichtung 1. Fig. 15. zeigt einen schematischen Schnitt entlang Linie XV-XV von Fig. 14. Bei der siebten Ausführungsform ist die Kammer 5 länglich ausgebildet. Der Kammer 5 sind vorzugsweise mehrere Elemente 13, insbesondere drei oder mehr Elemente, zugeordnet, die nacheinander bzw. in einer bestimmten Sequenz niederdrückbar bzw. betätigbar sind. So ist die Realisierung einer mikrofluidischen Pumpe möglich, ohne dass sich die Elemente 13 in Pumprichtung, also längs der Kammer 5 bewegen müssen. Vielmehr genügt hier die koordinierte Bewegung quer oder senkrecht zur Flachseite des Trägers 3 bzw. zur Längserstreckung der Kammer 5, um durch entsprechend nacheinander erfolgendes Zusammendrücken der Kammer 5 einen Nettofluss des Fluids, beispielsweise aus dem ersten Kanal 9 in die Kammer 5 und weiter in den zweiten Kanal 10 zu erzeugen.

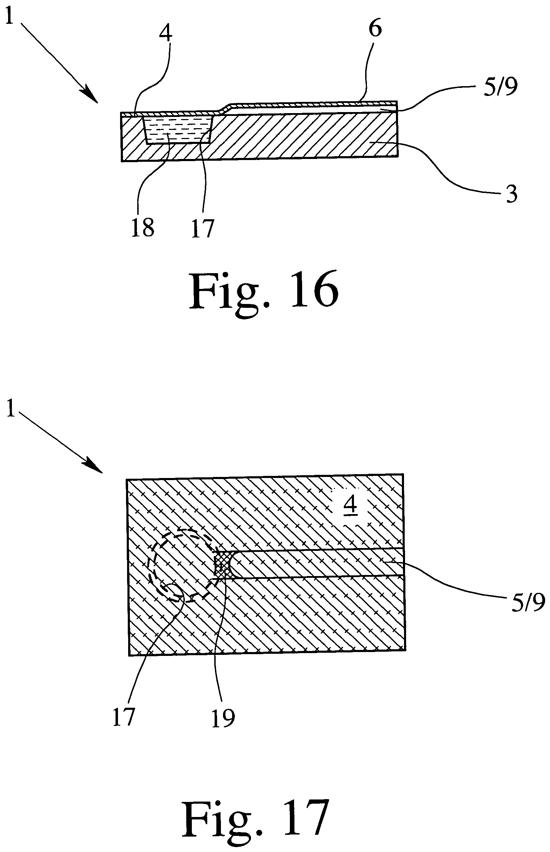

Fig. 16 zeigt in einem schematischen Schnitt eine achte Ausführungsform der vorschlagsgemäßen Vorrichtung 1. Hier geht es darum, dass die bereits auflaminierte Deckfolie 3 durch Hitze- und Druckeinwirkung in einem ersten Bereich derart zu modifizieren bzw. zu beeinflussen, dass sich die Deckfolie 4 in einem zum ersten Bereich benachbarten zweiten Bereich wieder von dem zugeordneten Träger 3 löst und insbesondere dreidimensional verformt bzw. aufwölbt. Fig. 16 zeigt den Zustand der bereits auflaminierten Deckfolie 4, die eine Ausnehmung 17 im Träger 3 und angrenzende Oberflächenbereiche überdeckt. Die Ausnehmung 17 ist hier beispielhaft mit einer Substanz 18 gefüllt.

Der schematischen Draufsicht gemäß Fig. 17 ist zu entnehmen, dass sich beispielsweise bereits ein vorgeformter Kanal 9 bis in die Nähe der Ausnehmung 17 erstreckt, jedoch noch durch einen auflaminierten, in Fig. 17 gestrichelt angedeuteten Bereich 19 der Deckfolie 4 von der Ausnehmung 17 fluidisch getrennt ist.

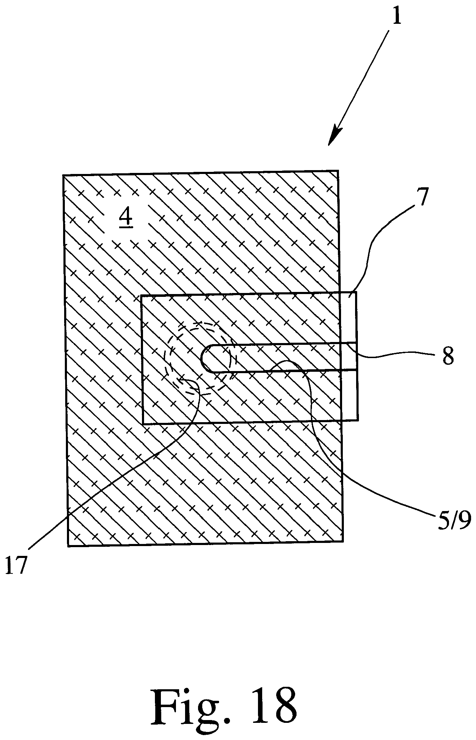

Durch Aufsetzen einer entsprechend geformten Maske 7 mit einer Ausnehmung oder Durchbrechung 8 im genannten Bereich 19 ist es nun möglich, durch Hitze- und Druckeinwirkung in dem sich anschließenden seitlichen Bereich die Deckfolie 4 im Bereich 19 wieder von dem Träger 3 zu lösen und insbesondere dreidimensional zu formen bzw. wölben. So wird eine fluidische Verbindung zwischen der Ausnehmung 17 und dem Kanal 9 bzw. zu der Substanz 18 hergestellt. Fig. 18 veranschaulicht den Zustand, wenn die Maske 7 bzw. sogenannte Termode oder dergleichen aufgesetzt ist und die fluidische Verbindung zu der Ausnehmung 17 bereits hergestellt ist.

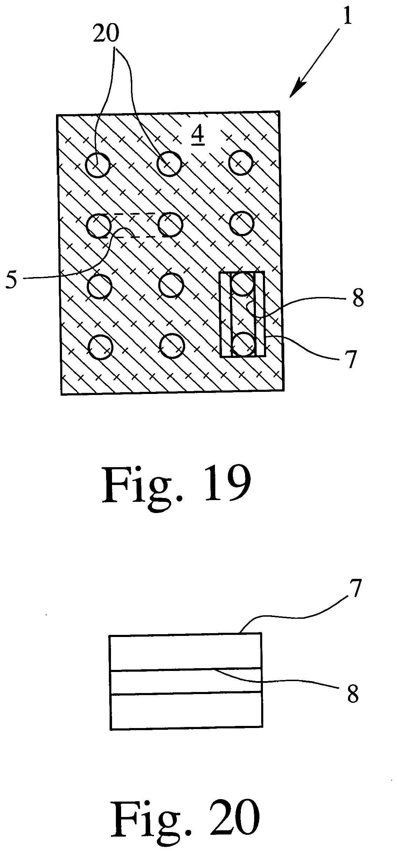

Das erläuterte Lösen der bereits auflaminierten Deckfolie 4 in bestimmten Bereichen 19 und insbesondere dessen definiertes dreidimensionales Formen bzw. Aufwölben kann auch für sonstige Zwecke eingesetzt werden. Beispielsweise können damit sehr einfach verschiedenste fluidische Verbindungen oder Netzwerke, beispielsweise für Testzwecke oder sonstige Zwecke, erzeugt werden. Alternativ oder zusätzlich kann auch nacheinander ein fluidisches Verbinden von verschiedenen Strukturen erfolgen. Fig. 19 zeigt beispielhaft einen mikrotiterplattenartigen Träger 3 mit verschiedenen fluidischen Näpfchen, Strukturen, Kanalöffnungen oder dergleichen, die generell mit dem Bezugszeichen 20 bezeichnet werden. Diese Strukturen 20 sind je nach Bedarf durch entsprechend formbare Kammern 5 verbindbar. Dies ist beispielhaft für zwei Strukturen 20 angedeutet, die über die gestrichelt dargestellte Kammer 5 miteinander verbunden sind.

Durch entsprechende Positionierung einer entsprechenden Termode oder Maske 7, wie beispielhaft in Fig. 20 angedeutet, ist es möglich, ganz gezielt, beispielsweise nur gerade, ggf. aber auch gekrümmte, gebogene, abgewinkelte oder sonstige, vorzugsweise kanalartige Kammern 5 zwischen den zunächst getrennten Strukturen 20 zu bilden oder wieder zu unterbinden. Dies erfolgt bspw. dadurch, dass die Maske 7 in den gewünschten Bereichen aufgesetzt wird. Hierbei ist nochmals anzumerken, dass aufgrund der Hitze- und Druckeinwirkung in den benachbarten Bereichen das Lösen der Deckfolie 4 von dem Träger 3 im Bereich der Ausnehmung bzw. Durchbrechung 8 der Maske 7 erfolgt und dementsprechend eine fluidische Verbindung hergestellt werden kann. Fig. 19 zeigt beispielhaft eine mögliche Anordnung der Maske 7 im rechten unteren Bereich, um zwei Strukturen 20 entsprechend miteinander verbinden zu können.

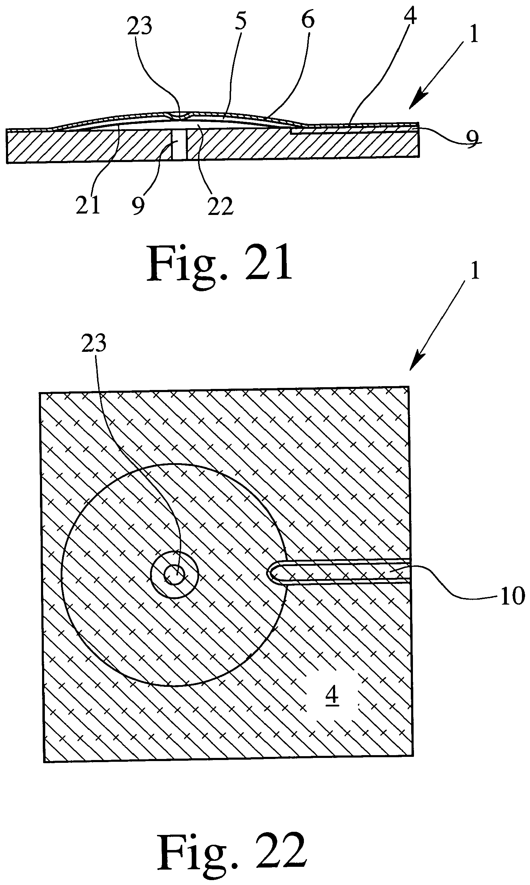

Fig. 21 zeigt in einem schematischen Schnitt eine zehnte Ausführungsform der vorschlagsgemäßen Vorrichtung 1. Die Vorrichtung 1 weist eine Membran 21 auf, die insbesondere für Abtrennzwecke, zur Filterung oder dergleichen, beispielsweise für die Bluttrennung, besonders bevorzugt zur Abscheidung von Blutplasma, eingesetzt wird.

Die Membran 21 ist vorzugsweise am Träger 3 angeordnet bzw. befestigt. Die Membran 21 kann auf jede geeignete Art und Weise mit dem Träger 3 verbunden werden, beispielsweise durch Kleben, Schweißen, Klemmen und/oder dergleichen, insbesondere auch Laminieren.

Die Membran 21 ist zumindest teilweise, insbesondere vollständig von der Deckfolie 4 überdeckt. Die Deckfolie 4 ist mit dem Träger 3 und/oder mit der Membran 21, insbesondere in deren Randbereich, verbunden, besonders bevorzugt darauf auflaminiert, wie bereits beschrieben. Die Deckfolie 4 ist vorzugsweise wiederum gewölbt bzw. dreidimensional verformt, um zwischen der Deckfolie 4 und der Membran 21 die Kammer 5 zu bilden.

Die Membran 21 ist bedarfsweise konkav bzw. von dem Träger 3 weg gewölbt. Dies kann durch entsprechende Strukturen, Stützelemente oder dergleichen und/oder durch eine entsprechende Vorformung erreicht werden. Alternativ oder zusätzlich kann die Membran 21 auch durch einen anstehenden Fluiddruck in dieser Weise verformt werden. Besonders bevorzugt wird eine möglichst großflächige Zuführkammer 22 zwischen der Membran 21 und dem Träger 3 bzw. auf der der Kammer 5 abgewandten Seite der Membran 21 gebildet.

Besonders bevorzugt ist die Deckfolie 4 mit der Membran 21 mittig und/oder in einem Bereich 23 verbunden. Dies erfolgt besonders bevorzugt unmittelbar beim Auflaminieren, insbesondere also durch entsprechende Ausbildung der Termode bzw. Maske 7, die hier nicht dargestellt ist.

Fig. 22 zeigt die bevorzugte Anordnung der zehnten Ausführungsform in einer schematischen Draufsicht. Insbesondere ist ersichtlich, dass die Deckfolie 4 vorzugsweise in einem Bereich 23 mit der Membran 21 verbunden ist, wo auf der gegenüberliegenden bzw. Unterseite bzw. dem Träger 3 zugewandten Seite die Zuführkammer 22 liegt und/oder eine Fluidzuführung über den ersten Kanal 9 - hier durch den Träger 3 - erfolgt. Jedoch ist auch ein anderer bzw. sonstiger fluidischer Anschluss möglich.

Der Draufsicht gemäß Fig. 22 ist zu entnehmen, dass an die zwischen der Membran 21 und der Deckfolie 4 gebildete Kammer 5 vorzugsweise der zweite Kanal 10 fluidisch angeschlossen ist.

Wenn der Zuführkammer 22 ein Fluid, beispielsweise Blut, zugeführt wird, wird das durch die Membran 21 hindurchtretende bzw. strömende Permeat, insbesondere Blutplasma, von der Kammer 5 aufgenommen und über den zweiten Kanal 10 abgeleitet. Aufgrund der besonders bevorzugt vorgesehenen mittigen Verbindung der Deckfolie 4 mit der Membran 21 wird in dem sich anschließenden Ringbereich der Kammer 5 eine besonders hohe Kapillarität erreicht. bzw. Kammerwand 6 Dies ist der Fluidfilterung bzw. Bluttrennung sehr zuträglich, wie Versuche gezeigt haben. Jedoch ist es alternativ oder zusätzlich zur Erreichung einer hohen Kapillarität in Kammer 5 auch möglich, die Deckfolie 4 bzw. Kammerwand 6 auf sonstige Weise - insbesondere in der Mitte - nahe an die Membran 21 heranzubringen - insbesondere an diese anzulegen - beispielsweise durch Andrücken oder Halten von außen oder auf sonstige geeignete Art und Weise.

Die Deckfolie 4 wird vorzugsweise wie bereits beschrieben unter Bildung der gewünschten Hohlstruktur bzw. der Kammer 5 auf den Träger 3 und hier insbesondere auch in dem mittigen Bereich auf die Membran 21 auflaminiert. Jedoch sind auch andere Aufbringungsmöglichkeiten möglich.

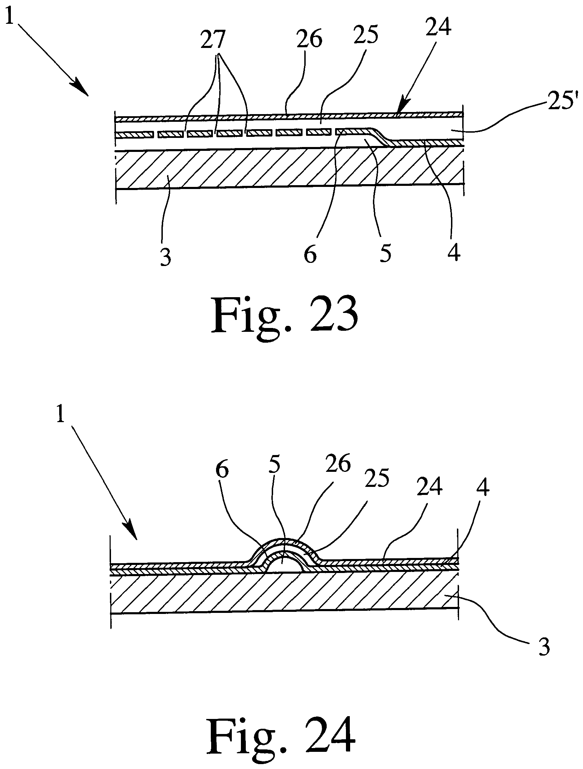

Fig. 23 zeigt in einem schematischen Schnitt eine elfte Ausführungsform der vorschlagsgemäßen Vorrichtung 1. Auf die vorzugsweise auflaminierte Deckfolie 4 ist hier zumindest partiell und/oder im Bereich der von der Deckfolie 4 gebildeten Kammer 5 eine Zusatzfolie 24 auflaminiert, die insbesondere im Bereich der Kammer 5 und/oder über der Deckfolie 4 eine Zusatzkammer 25 bildet.

Die Zusatzkammer 25 ist insbesondere über und/oder auf einer Flachseite der Kammer 5 angeordnet. Jedoch sind auch andere Konfigurationen und Anordnungen möglich.

Die Zusatzfolie 24 bildet vorzugsweise wieder allein durch das Auflaminieren eine dreidimensional geformte oder gewölbte Zusatzwand 26, die die Zusatzkammer 25 zumindest partiell begrenzt, wie in Fig. 23 schematisch dargestellt. Es ist anzumerken, dass die Zusatzfolie 24 jedoch auch auf jede sonstige geeignete Art und Weise aufgebracht werden kann. Entsprechend kann die dreidimensionale Formung bzw. Wölbung der Zusatzfolie 24 bzw. Kammerwand 26 wahlweise entweder direkt durch das Auflaminieren und/oder auf sonstige Weise, beispielsweise durch Einleitung von Druckgas, Ausbildung von sich nicht verbindenden Bereichen oder dergleichen erreicht werden. Entsprechendes gilt für die Deckfolie 24 und die davon gebildete Kammer 5.

Die Zusatzkammer 25 kann sich bedarfsweise nur im Wesentlichen im Bereich der Kammer 5 über die Deckfolie 4 erstrecken. Vorzugsweise erstreckt sich die Zusatzkammer 25 jedoch zumindest an einer Seite oder in einem Bereich über die Kammer 5 seitlich hinaus und bildet dann beispielsweise einen etwas verdickten Zusatzkammerbereich 25', wie in Fig. 23 auf der rechten Seite angedeutet. Dieser Teil 25' der Zusatzkammer 25 kann beispielsweise an einen nicht dargestellten Kanal 10 oder dergleichen angeschlossen sein. Die Kammer 5 kann ihrerseits beispielsweise an einen nicht dargestellten Kanal 9 oder dergleichen angeschlossen sein.

Die übereinanderliegenden Kammern 5 und 25 können für verschiedenste Zwecke genutzt werden. Beispielsweise kann beim Eindrucken der Zusatzkammer 25 durch ein nicht dargestelltes Element 13 oder dergleichen zunächst erst ein Fluss in der Zusatzkammer 25 gedrosselt oder unterbunden werden kann. Je nach herrschenden Druckverhältnissen, Kammerdimensionierung, Dimensionierung der Folien 4 und 24 und sonstigen Parametern kann gleichzeitig, zuerst oder erst danach ein Fluss durch die Kammer 5 gedrosselt oder gar gesperrt werden. Entsprechendes gilt umgekehrt auch beim Öffnen oder Freigeben der Kammern 5 und 25.

Weiter kann mittels eines gemeinsamen Elements 13 beispielsweise auch ein gleichzeitiges Mischen von getrennten Flüssigkeiten in den vorzugsweise fluidisch getrennten Kammern 5 und 25 erfolgen.

Beim Darstellungsbeispiel sind optional fluidische Verbindungen 27 im Bereich der Kammerwand 6 zur Zusatzkammer 25 hin vorgesehen. Diese Verbindungen 27 können beispielsweise durch entsprechende Poren, Ausnehmungen, Bohrungen, Löcher oder dergleichen gebildet sein. Bedarfsweise kann auch nur eine einzige Verbindung 27 vorgesehen sein.

Die fluidischen Verbindungen 27 können - insbesondere bei sehr kleinem Durchmesser oder Querschnitt - einen Kapillarstopp bilden, so dass beispielsweise Flüssigkeit aus der Kammer 5 nur dann in die Zusatzkammer 25 fließen kann, wenn der Flüssigkeitsdruck in der Kammer 5 stark erhöht wird oderwenn die Kammerwandung 26 zumindest temporär derart verformt wird, dass diese an die Kammerwand 6 stark angenähert wird oder diese - insbesondere im Bereich einer Verbindung 27 - sogar berührt. In diesem Fall wird dann entsprechend ebenfalls ein Bereich sehr hoher Kapillarität gebildet, so dass der Kapillarstopp überwunden und Flüssigkeit aus der Kammer 5 in die Zusatzkammer 25 strömen kann.

Fig. 24 zeigt in einem schematischen Schnitt eine zwölfte Ausführungsform der vorschlagsgemäßen Vorrichtung 1. Die zwölfte Ausführungsform ist der elften Ausführungsform sehr ähnlich. Die Kammer 5 bildet hier einen insbesondere zumindest im wesentlichen länglichen Kanal. Die vorzugsweise darüber laminierte Zusatzfolie 24 bildet insbesondere darüber bzw. entlang der Kammer 5 die Zusatzkammer 25. Diese umgibt die Kammer 5 besonders bevorzugt im wesentlichen halbzylindrisch und/oder ist koaxial zur Kammer 5 angeordnet. Wenn durch die Kammer 5 und die Zusatzkammer 25 unterschiedliche Flüssigkeiten bzw. sonstige Fluide geleitet werden, ist insbesondere in einem sich anschließenden gemeinsamen Kanal (nicht dargestellt) eine hydrodynamische Fokussierung möglich. Jedoch kann die Konfiguration gemäß Fig. 24 auch für sonstige Zwecke eingesetzt werden.

Generell können die verschiedenen Ausführungsformen auch beliebig miteinander kombiniert werden. Weiter können auch einzelne Aspekte und Merkmale der verschiedenen Ausführungsformen beliebig miteinander kombiniert und/oder bei sonstigen ähnlichen Vorrichtungen und Verfahren - insbesondere in der Mikrofluidik - eingesetzt werden.

## Patentansprüche

1. Verfahren zur Herstellung einer Vorrichtung (1) zur Aufnahme oder Manipulation eines Fluids,
wobei eine flache und/oder nicht vorgeformte bzw. nicht strukturierte Deckfolie (4) auf einen Träger (3) laminiert wird,
**dadurch gekennzeichnet,**
**dass** zum Laminieren eine Maske (7) oder ein beheizter Stempel mit mindestens einer Ausnehmung oder Durchbrechung (8) auf die als Heißsiegelfolie ausgebildete Deckfolie (4) unter Hitzeeinwirkung bei 80 bis 100 °C gepresst wird, sodass ausschließlich hierdurch die Deckfolie (4) im Bereich der Ausnehmung oder Durchbrechung (8) nicht mit dem Träger (3) und/oder nicht mit einer Membran (21) verbunden, sondern gewölbt wird.

2. Verfahren nach Anspruch 1, **dadurch gekennzeichnet, dass** die Maske (7) flach und/oder plattenförmig ist.

3. Verfahren nach Anspruch 1 oder 2, **dadurch gekennzeichnet, dass** die Maske (7) aus Metall, insbesondere Blech, hergestellt ist.

4. Verfahren nach einem der voranstehenden Ansprüche, **dadurch gekennzeichnet, dass** ein Träger (3) aus Kunststoff, insbesondere Polystyrol oder Polycarbonat, verwendet wird.

5. Verfahren nach einem der voranstehenden Ansprüche, **dadurch gekennzeichnet, dass** der Träger (3) plattenförmig, flach und/oder eben ausgebildet ist.

6. Verfahren nach einem der voranstehenden Ansprüche, **dadurch gekennzeichnet, dass** die Deckfolie (4) von einer Zusatzfolie (24) zumindest partiell und/oder im Bereich der Kammer (5) überdeckt wird, wobei zwischen der Deckfolie (4) und der Zusatzfolie (24) eine Zusatzkammer (25) gebildet wird.

7. Verfahren nach Anspruch 6, **dadurch gekennzeichnet, dass** die flache und/oder nicht vorgeformte Zusatzfolie (24) auf die Deckfolie (4) auflaminiert wird und/oder die Zusatzfolie (24) eine insbesondere allein durch das Auflaminieren dreidimensional geformte oder gewölbte Zusatzwand (26) bildet, die die Zusatzkammer (25) partiell begrenzt.

8. Verfahren nach einem der voranstehenden Ansprüche, **dadurch gekennzeichnet, dass** die Kammer (5) ringförmig ausgebildet und/oder zwischen der Deckfolie (4) und der Membran (21) gebildet wird, insbesondere wobei die Deckfolie (4) vorzugsweise in der Mitte der Kammer (5) mit der Membran (21) verbunden wird.

9. Verfahren nach einem der voranstehenden Ansprüche, **dadurch gekennzeichnet, dass** die Deckfolie (4) auf eine Flachseite (F) des Trägers (3) laminiert wird.

10. Verfahren nach einem der voranstehenden Ansprüche, **dadurch gekennzeichnet, dass** die Deckfolie (4) mittels eines Rollenlaminators mit der Maske (7) auf den Träger (3) laminiert wird.

11. Verfahren nach einem der Ansprüche 1 bis 9, **dadurch gekennzeichnet, dass** die Deckfolie (4) mittels eines Stempellaminators mit der Maske (7) auf den Träger (3) laminiert wird.

12. Verfahren nach einem der voranstehenden Ansprüche, **dadurch gekennzeichnet, dass** die Vorrichtung (1) zum Pumpen, Mischen oder Abtrennen oder als Ventil oder Drossel verwendet wird.

## Claims

1. Method for producing a device (1) for the intake or manipulation of a fluid, wherein a flat and/or non-preformed and/or non-structured cover film (4) is laminated onto a carrier (3),
**characterised in**
**that** for the lamination, a mask (7) or a heated punch with at least one recess or opening (8) is pressed onto the cover film (4), which is formed as a heat-sealing film, under the action of heat at 80 to 100°C so that, exclusively hereby, the cover film (4) in the region of the recess or opening (8) is not connected to the carrier (3) and/or is not connected to a membrane (21), but is curved.

2. Method according to claim 1, **characterised in that** the mask (7) is flat and/or plate-shaped.

3. Method according to claim 1 or 2, **characterised in that** the mask (7) is produced from metal, in particular sheet metal.

4. Method according to any one of the preceding claims, **characterised in that** a carrier (3) made of plastic, in particular polystyrene or polycarbonate, is used.

5. Method according to any one of the preceding claims, **characterised in that** the carrier (3) is plate-shaped, flat and/or planar.

6. Method according to any one of the preceding claims, **characterised in that** the cover film (4) is covered by an additional film (24) at least partially and/or in the region of the chamber (5), wherein an additional chamber (25) is formed between the cover film (4) and the additional film (24).

7. Method according to claim 6, **characterised in that** the flat and/or non-preformed additional film (24) is laminated onto the cover film (4) and/or the additional film (24) forms an additional wall (26), which is three-dimensionally shaped or curved in particular solely by the lamination, and which partially delimits the additional chamber (25).

8. Method according to any one of the preceding claims, **characterised in that** the chamber (5) is annular and/or is formed between the cover film (4) and the membrane (21), in particular wherein the cover film (4) is connected to the membrane (21) preferably in the centre of the chamber (5).

9. Method according to any one of the preceding claims, **characterised in that** the cover film (4) is laminated onto a flat side (F) of the carrier (3).

10. Method according to any one of the preceding claims, **characterised in that** the cover film (4) is laminated onto the carrier (3) by means of a roller laminator with the mask (7).

11. Method according to any one of claims 1 to 9, **characterised in that** the cover film (4) is laminated onto the carrier (3) by means of a punch laminator with the mask (7).

12. Method according to any one of the preceding claims, **characterised in that** the device (1) is used for pumping, mixing or separation or as a valve or throttle.

## Revendications

1. Procédé de fabrication d'un dispositif (1) de réception ou de manipulation d'un fluide,
un film de recouvrement (4) plat et/ou non préformé et/ou non structuré étant stratifié sur un support (3),
**caractérisé**
**en ce que** pour la stratification, un masque (7) ou un poinçon chauffé ayant au moins une cavité ou une découpe (8) est pressé sur le film de recouvrement (4) conçu sous la forme d'un film thermoscellable sous l'action de la chaleur comprise entre 80 et 100 °C, et exclusivement de cette manière, le film de recouvrement (4), dans la zone de la cavité ou de la découpe (8), n'est pas relié au support (3) et/ou à une membrane (21), mais est voûté.

2. Procédé selon la revendication 1, **caractérisé en ce que** le masque (7) est plat et/ou en forme de plaque.

3. Procédé selon la revendication 1 ou 2, **caractérisé en ce que** le masque (7) est constitué de métal, en particulier de tôle.

4. Procédé selon une des revendications précédentes, **caractérisé en ce qu'**un support (3) en plastique, en particulier en polystyrène ou polycarbonate, est utilisé.

5. Procédé selon une des revendications précédentes, **caractérisé en ce que** le support (3) est formé en forme de plaque, plat et/ou plan.

6. Procédé selon une des revendications précédentes, **caractérisé en ce que** le film de recouvrement (4) est recouvert par un film supplémentaire (24) au moins partiellement et/ou dans la zone de la chambre (5), entre le film de recouvrement (4) et le film supplémentaire (24) étant formée une chambre supplémentaire (25).

7. Procédé selon la revendication 6, **caractérisé en ce que** le film supplémentaire (24) plat et/ou non préformé est stratifié sur le film de recouvrement (4) et/ou le film supplémentaire (24) forme une paroi supplémentaire (26) voûtée ou formée en trois dimensions en particulier uniquement par stratification, qui délimite partiellement la chambre supplémentaire (25).

8. Procédé selon une des revendications précédentes, **caractérisé en ce que** la chambre (5) est annulaire et/ou est formée entre le film de recouvrement (4) et la membrane (21), en particulier le film de recouvrement (4) étant relié à la membrane (21) de préférence au centre de la chambre (5).

9. Procédé selon une des revendications précédentes, **caractérisé en ce que** le film de recouvrement (4) est stratifié sur un côté plat (F) du support (3).

10. Procédé selon une des revendications précédentes, **caractérisé en ce que** le film de recouvrement (4) est stratifié au moyen d'un appareil de stratification à rouleaux avec le masque (7) sur le support (3).

11. Procédé selon une des revendications 1 à 9, **caractérisé en ce que** le film de recouvrement (4) est stratifié au moyen d'un appareil de stratification à poinçon avec le masque (7) sur le support (3).

12. Procédé selon une des revendications précédentes, **caractérisé en ce que** le dispositif (1) est utilisé pour le pompage, le mélange ou la séparation ou en tant que soupape ou restricteur.
